# EUROPEAN PATENT APPLICATION

(11) **EP 4 687 386 A1**
(43) Date of publication of application: **04.02.2026**
(21) Application number: 24307224.6
(22) Date of filing: 20.12.2024
(51) Int. Cl.: H05K 7/20, G06F 1/20

(54) **DATACENTER FLUID COOLING ARRANGEMENT WITH LEAKAGE DETECTION**

(30) Priority: 02.08.2024 EP 24306314
(71) Applicant: OVH, 59100 Roubaix (FR)
(72) Inventor: CHEHADE, Ali, 59283 Moncheaux (FR); HNAYNO, Mohamad, 59110 La Madeleine (FR); GENELLE, Louis, 59279 Halluin (FR)
(74) Representative: BCF Global

(57) **Abstract**

The invention relates to a fluid cooling system for a datacenter, wherein the fluid cooling system comprises a leakage detection device, comprising a leakage sensor, the leakage sensor comprising an electrical circuit configured to be open in normal use conditions of the fluid cooling system and to be closed in case of liquid leak, the leakage detection device comprising said control valve as an inlet shut off actuator when a liquid leakage is detected, and a check valve to act as the outlet shut off actuator when a liquid leakage is detected.

## Description

### FIELD

The present technology generally relates to the detection of liquid leakage out of a liquid cooling arrangement for a datacenter.

### BACKGROUND

Datacenters house multitudes rack-mounted electronic processing equipment. In operation, such electronic processing equipment generates a substantial amount of heat that must be dissipated to avoid electronic component failures and ensure continued efficient processing operations.

To this end, various liquid cooling measures have been implemented to facilitate the dissipation of heat generated by the electronic processing equipment. One such measure employs liquid block cooling techniques for directly cooling one or more heat-generating processing components. This technique utilizes liquid cooling blocks having internal channels that receive cooling liquid from a cooling liquid source, *e.g.,* heat exchangers, dry coolers, *etc.,* via a liquid cooling circuit arrangement to circulate the cooling liquid throughout the equipment. As such, the liquid cooling blocks are positioned to be in direct thermal contact with the heat-generating components, so that the received cooling liquid absorbs the generated heat and the heated liquid is circulated, via the cooling circuit arrangement, back to cooling liquid source for re-cooling.

Liquid cooling implies a strict detection of liquid leaking out of the liquid cooling arrangement to avoid any electrical shortage.

With this said, there remains an interest in improving the detection of liquid leakage in datacenters liquid cooling arrangements.

The subject matter discussed in the background section should not be assumed to be prior art merely as a result of its mention in the background section. Similarly, a problem mentioned in the background section or associated with the subj ect matter of the background section should not be assumed to have been previously recognized in the prior art. The subject matter in the background section merely represents different approaches.

### SUMMARY

Embodiments of the present technology have been developed based on certain drawbacks associated with conventional cooling techniques and implementations.

In one aspect, the inventive concepts of the present technology relates to a fluid cooling system for rack-mounted data processing assemblies, comprising:
a cooling facility to supply a cooling liquid to the rack-mounted data processing assemblies and receive a heated liquid from the rack-mounted data processing assemblies;
a liquid distribution circuit to convey a cooling liquid from the liquid cooling facility to the rack-mounted data processing assemblies, the liquid distribution circuit comprising at least one heat exchanger (ALHEX) configured to cool an air flow of the rack with the cooling liquid;
wherein, each of the rack-mounted data processing assemblies comprises:
   at least one heat-generating electronic processing element and at least one liquid cooling block arranged to be in respective thermal contact with the at least one heat-generating electronic processing element, the at least one liquid cooling block being fluidly-coupled to the liquid distribution circuit to receive the cooling liquid and circulate therethrough, and
   a control valve respectively arranged to be fluidly-coupled to the at least one liquid cooling block of the corresponding rack-mounted data processing assembly,
   wherein at least one electronic processing element is being air-cooled,
   wherein the fluid cooling system comprises a leakage detection device to detect leakage of liquid,
   the leakage detection device comprising said control valve as an inlet shut off actuator when a liquid leakage is detected, and a check valve to act as the outlet shut off actuator when a liquid leakage is detected.

Thanks to the present disclosure, there is provided a reliable method to control the temperatures of the air and liquid flows of the arrangement.

In some non-limiting embodiments, the system comprises a bypass line connected to a rack inlet and to a rack outlet.

In some non-limiting embodiments, the bypass line comprises a first valve, called bypass inlet valve, fluidically disposed downstream the control valve and upstream the rack mounted assemblies, the bypass inlet valve being configured to be closed in normal use conditions of the fluid cooling system.

In some non-limiting embodiments, the bypass line comprises a second valve, called bypass outlet valve, fluidically disposed downstream the control valve and the rack mounted assemblies and upstream the check valve, the bypass outlet valve being configured to be closed in normal use conditions of the fluid cooling system.

In some non-limiting embodiments, the control valve is a smart control valve, configured to be pressure independent and controls the flow rate of the cooling fluid of the corresponding rack-mounted data processing assembly based on detected temperatures and monitored flow rate.

In some non-limiting embodiments, the control valve is located in the rack inlet and the check valve is located in the rack outlet.

In some non-limiting embodiments, the leakage device comprises a leakage sensor, the leakage sensor comprising an electrical circuit configured to be open in normal use conditions of the fluid cooling system and to be closed in case of liquid leak and/or a pressure sensor

The present technology also related to a method for detecting liquid leakage in the fluid cooling as already described, comprising: alerting a controller that the leakage sensor has detected a liquid leakage, and shutting off the control valve and shutting off the check valve.

In some non-limiting embodiments, shutting off the control valve is controlled by a control panel of the fluid cooling system.

In some non-limiting embodiments, shutting off the check valve is automatically done when a pressure of liquid upstream the check valve is lower than a pressure of liquid downstream the check valve.

In some non-limiting embodiments, the method comprises:
- comparing liquid pressure in the system, for instance in the rack, to a pressure threshold and/or
- comparing pump speed to a speed threshold,
the shutting off the smart valve and the check valve occurring only if the step of alerting a controller that the leakage sensor has detected a liquid leakage occurs and if
- the liquid pressure is less than or equal to the pressure threshold, and/or
- the pump speed is higher than or equal to the speed threshold.

In some non-limiting embodiments, the method comprises:
- comparing the flow rate to a pre-determined value,
the shutting off the smart valve and the check valve occurs only if the step of alerting a controller that the leakage sensor has detected a liquid leakage occurs and if
- the liquid pressure is less than or equal to the pressure threshold, and/or
- the pump speed is higher than or equal to the speed threshold,
and if
the flow rate is higher the pre-determined value.

In some non-limiting embodiments, the method comprises a maintenance step ulterior to the step of shutting off the control valve and the check valve, said step comprising opening the bypass inlet valve and bypass outlet valve.

The present technology also relates to a computer program comprising instructions which, when the program is executed by a computer, cause the computer to carry out the steps of the method as already described.

The present technology also relates to a computer-readable medium comprising instructions which, when executed by a computer, cause the computer to carry out the steps of the method as already described.

Advantageously, if, at the current input cooling liquid temperature (T_{R-i}), internal temperatures of said at least one air cooled electronic processing element (T_{air cooled IT}) are greater than a predetermined limit, incrementing the fan speed.

Advantageously, the method further comprises determining whether at the current input cooling liquid temperature (T_{R-i}), internal temperatures of said at least one air cooled electronic processing element (T_{air cooled IT}) are less than a predetermined limit after the fan speed has been incremented.

Advantageously, if the incremented fan speed is a maximal speed, issuing an indication that the fan speed has reached its maximal speed.

Advantageously, the method further comprises: measuring hot air flow temperatures (Tₐᵢᵣ₋ₕ) before the air flows cross the at least one heat exchanger and, when the internal temperatures of said at least one air cooled electronic processing element (T_{air cooled IT}) are less than a predetermined limit, determining whether at the current input cooling liquid temperature (T_{R-i}), the hot air flow temperatures (Tₐᵢᵣ₋ₕ) are less than a predetermined limit.

Advantageously, when the hot air flow temperatures (Tₐᵢᵣ₋ₕ) are greater than a predetermined limit, the method comprises incrementing the fan speed.

Advantageously, the method comprises determining whether at the current input cooling liquid temperature (T_{R-i}), hot air flow temperatures (Tₐᵢᵣ₋ₕ) are less than a predetermined limit after the fan speed has been incremented.

Advantageously, if the incremented fan speed is a maximal speed, issuing an indication that the fan speed has reached its maximal speed.

Advantageously, the method further comprises: measuring cold air flow temperatures (T_{air-c}) after the air flows have crossed the at least one heat exchanger and, determining differences (Pin_{c}) between said cold air flow temperatures (T_{air-c}) and the current input cooling liquid temperature (T_{R-i}), called cold differences, and, when the hot air flow temperatures (Tₐᵢᵣ₋ₕ) are less than a predetermined limit, determining whether at the current input cooling liquid temperature (T_{R-i}), the cold differences (Pin_{c}) are less than a predetermined limit.

Advantageously, when the cold differences (Pin_{c}) are greater than a predetermined limit, the method comprises decrementing the fan speed.

Advantageously, the method comprises determining whether at the current input cooling liquid temperature (T_{R-i}), the cold differences (Pin_{c}) are less than a predetermined limit after the fan speed has been decremented.

Advantageously, if the decremented fan speed is a minimal speed, issuing an indication that the fan speed has reached its minimal speed.
Advantageously, the method further comprises that, when the current differential temperature is greater than the target differential temperature value, incrementing the liquid flow rate of the corresponding smart control valve.

Advantageously, the method further comprises that, when the current differential temperature is less than the target differential temperature value, decrementing the liquid flow rate of the corresponding smart control valve after confirming that the decremented flow rate is not below a minimum flow rate limit.

In a related aspect of the inventive concepts, the present technology relates to a fluid cooling system for rack-mounted data processing assemblies, comprising: a liquid cooling facility to supply a cooling liquid to the rack-mounted data processing assemblies and receive a heated liquid from the rack-mounted data processing assemblies; a liquid distribution circuit to convey a cooling liquid from the liquid cooling facility to the rack-mounted data processing assemblies, the liquid distribution circuit comprising at least one heat exchanger (ALHEX) configured to cool an air flow of the rack with the cooling liquid; wherein, each of the rack-mounted data processing assemblies comprises: at least one heat-generating electronic processing element and at least one liquid cooling block arranged to be in respective thermal contact with the at least one heat-generating electronic processing element, the at least one liquid cooling block being fluidly-coupled to the liquid distribution circuit to receive the cooling liquid and circulate therethrough, and a smart control valve respectively arranged to be fluidly-coupled to the at least one liquid cooling block of the corresponding rack-mounted data processing assembly, the smart control valve is configured to be pressure independent and controls the flow rate of the cooling fluid of the corresponding rack-mounted data processing assembly based on detected temperatures and monitored flow rate; wherein at least one electronic processing element is being air-cooled by at least one fan; wherein the system is configured to operate the method as already described.

Advantageously, the fluid cooling system comprises a leakage detector system to detect liquid leak. Preferably, the leakage detector system comprises an electrical circuit configured to be open in normal use conditions of the fluid cooling system and to be closed in case of liquid leak.

The invention also relates to a computer program comprising instructions which, when the program is executed by a computer, cause the computer to carry out the steps of the method as already described.

The invention also relates to a computer-readable medium comprising instructions which, when executed by a computer, cause the computer to carry out the steps of the method as already described.

The invention relates to a leakage detection system, particularly for a fluid cooling system for rack-mounted data processing assemblies comprising an electrical circuit configured to be open in normal use conditions of the fluid cooling system and to be closed in case of liquid leak.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task at hand.

In the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

In the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 depicts a functional block diagram of an internal server cluster configuration of a datacenter server rack, focusing on liquid cooling, in accordance with the non-limiting embodiments of the present disclosure;
FIG. 2 depicts a functional block diagram of a cooling arrangement for the system of FIG. 1 in accordance with some non-limiting embodiments of the present disclosure;
FIG. 3 depicts a schematic physical view of a rack equipped with the cooling arrangement of figure 2, showing the positioning of sensors, and a leakage sensor, in accordance with some non-limiting embodiments of the present disclosure;
FIG. 4a depicts a schematic physical view of a rack equipped with the cooling arrangement of figure 2, in accordance with some non-limiting embodiments of the present disclosure, in normal use conditions;
FIG. 4b depicts a schematic physical view of the rack of figure 5, during maintenance;
FIG. 5 illustrates a flow diagram of a method for detecting liquid leaking out of a rack of the preceding figures, in accordance with the nonlimiting embodiments of the present technology.
FIG. 6 is a block diagram of modules that can implement the method of FIG. 5 in accordance with some non-limiting implementations of the present technology.
FIG. 7 illustrates a flow diagram of an operational continuous process for controlling and balancing a liquid cooling system for rack-mounted processing assemblies, in accordance with the nonlimiting embodiments of the present technology.
FIG. 8 to FIG. 15 illustrate each a flow diagram of a respective subroutine for the process of FIG. 4.

### DETAILED DESCRIPTION

The instant disclosure is directed to addressing at least some of the issues associated with the conventional use of liquid cooling arrangements of datacenters.

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative systems embodying the principles of the present technology.

With these fundamentals in place, we will now consider some non-limiting examples to illustrate the implementations of the various inventive aspects of the present disclosure.

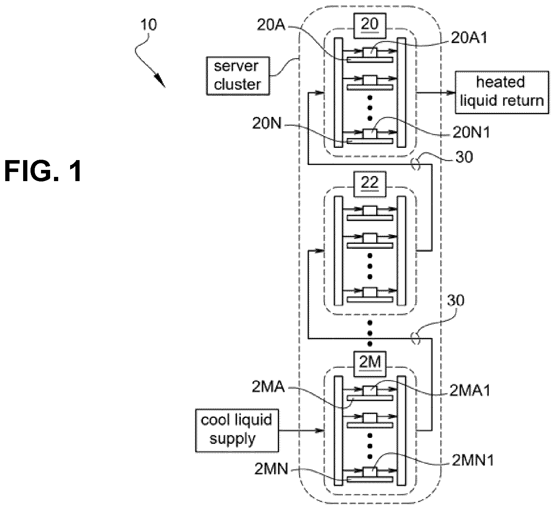

FIG. 1 depicts a functional block diagram of a representative internal server cluster configuration **10** of a datacenter server rack, in accordance with the non-limiting embodiments of the present disclosure. The representative server cluster **10** configuration comprises a plurality of server sub-clusters **20-2M,** in which each server sub-cluster **20-2M** correspondingly comprises a plurality of data processing assemblies **20A-20N** to **2MA-2MN** containing heat-generating electronic processing components.

As shown, each of the data processing assemblies **20A-20N** to **2MA-2MN** incorporates at least one respective liquid cooling block unit **20A1-20N1** to **2MA1-2MN1** disposed in direct thermal contact with the heat-generating electronic processing components. Each of the liquid cooling block units **20A1-20N1** to **2MA1-2MN1** is configured with internal conduits (*not shown*) to accommodate the circulated flow of channelized cooling liquid therethrough. The channelized cooling liquid is provided by a cooling liquid supply that is serially conveyed to each of the liquid cooling block units **20A1-20N1** to **2MA1-2MN1** via an internal server cluster liquid circulating channel **30** to absorb the thermal energy from the heat-generating electronic components and discharge the heated liquid therefrom.

Other components of the data processing assemblies **20A-20N** to **2MA-2MN** that usually generate less heat can be air-cooled thanks to fan(s) of a fluid cooling arrangement **100** described later. Heat-generating components are for instance graphics processing units (GPU) and/or central processing units (CPU). Other components are for instance random-access memory (RAM), hard drives ...

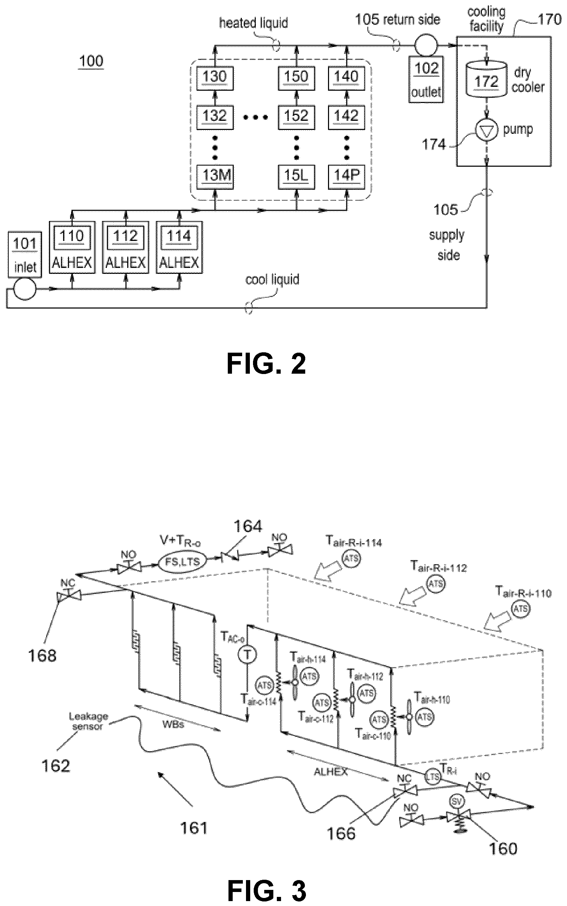

Given the internal datacenter server cluster **10** configuration described above, FIG. 2 depicts a functional block diagram of the fluid cooling arrangement **100,** in accordance with non-limiting embodiments of the present disclosure. While the embodiments and implementations described herein are directed to a datacenter rack, it will be appreciated that extending such concepts to encompass multiple datacenter racks are clearly within the scope of the present technology.

As shown, fluid cooling arrangement **100** comprises a single liquid distribution circuit **105** configured with a supply side to supply a cooling liquid to the server clusters **130-13M, 140-14P, 150-15L** of a rack from facility for cooling the liquid, for instance a dry cooling facility, **170,** and a return side to return a heated liquid from the server clusters back to the dry cooling facility 170 **170** for recooling and recirculation back to the server clusters **130-15L.** As noted above relative to FIG. 1, each of the server clusters **130-15L** comprise data processing assemblies (*see, e.g.,* FIG. 1 **20A-20N** to **2MA-2MN)** that incorporate at least one corresponding liquid cooling block unit for direct thermal contact with the heat generating electronic components of the data processing assemblies for dissipation of heat therefrom. The liquid cooling blocks are also called water blocks (WB on FIG. 3).

The liquid distribution circuit **105** is configured with a liquid distribution inlet 101 along the supply side for supplying the cooling liquid to the fluidly-coupled server clusters **130-15L** and a liquid distribution outlet **102** along the return side for receiving a heated liquid from the server clusters **130-15L** and returning the heated liquid back to the dry cooling facility 170 **170** for recooling and recirculation back to the server clusters **130-15L.** The liquid distribution circuit **105** may be constructed from flexible materials (*e.g*., rubber, plastic, *etc*.), rigid materials (*e.g*., metal, PVC piping, *etc*.), or any combination of thereof. It will be appreciated that the conveyed liquid may include water, alcohol, or any suitable liquid capable of sustaining adequate cooling temperatures.

The dry cooling facility 170 **170** may comprise a dry cooler unit **172** configured to process and recondition received liquids from the server racks to provide cooling liquid for recirculation back to the server clusters **130-15L** via the liquid distribution circuit **105.** The dry cooling facility 170 **170** may further comprise a pump **174** configured to provide the necessary pressure increase and volume flow rate of the cooling liquid from the dry cooler unit **172** throughout the liquid distribution circuit **105.**

The fluid cooling arrangement **100** further includes a plurality of air-to-liquid heat exchangers (ALHEXs) **110-114.** In the illustrated embodiment, the ALHEXs **110-114** are fluidly connected in parallel via the liquid cooling circuit **105** while also being fluidly coupled to the server clusters **130-15L** via the liquid cooling circuit **105.** It will be appreciated, however, that the ALHEXs **110-114** may be fluidly interconnected in other configurations, such as, for example, in series via the liquid cooling circuit 105 without departing from the concepts of the disclosed technology. The heat exchangers are of any appropriate types, like heat exchangers with tubes, plates, fins ...

The ALHEXs **110-114** function to sufficiently cool the ambient air surrounding the server clusters **130-15L.** The ALHEXs **110-114** may embody any suitable configuration that reduces temperatures of supplied air flow (e.g. by compact fans), such as, internal cooling coils, heat extracting air flow fins, *etc.* The ALHEXs **110-114** may be, for example, disposed on rear doors of the rack hosting the server clusters **130-15L,** to directly cool the air exiting the server clusters **130-15L,** warmed by the air-cooled components therein.

The evolution of the liquid temperature in the distribution circuit **105** can be described as follows. The liquid flow egresses out of the dry cooling facility 170 **170** and enters the distribution circuit **105** at a "cold" temperature. It is continuously warmed up in the circuit **105,** in the heat exchangers ALHEX **110-114** first then into the server clusters **130-15L.** After the "warm" liquid has been internally circulated through each of the data processing assemblies and cooling units of the server clusters **130-15L,** the liquid egressing out of the standard priority server clusters **130-15L** is heated. The "heated" liquid is forwarded to the return side of the liquid distribution circuit 105 for return back to the dry cooling facility 170 **170** for recooling and recirculation back to all the server clusters **130-15L.** In certain implementations, the heated liquid temperature may range from approximately 45°C to 65°C, while the "cold" temperature is chosen between 20°C to 40°C.

As shown on FIG. 3, several sensors are positioned in the fluid cooling arrangement **100.** The arrangement **100** comprises liquid temperature sensors LTS installed preferably:
- at the inlet of each rack, the measured temperature being the inlet liquid temperature, T_{R-i} (or "Tᵢₙ")
- at the outlet of each rack, the measured temperature being the outlet liquid temperature T_{R-o} (or "Tₒᵤₜ")

The arrangement **100** also comprises air temperature sensors ATS installed preferably upstream and downstream each heat exchanger ALHEX **110-114.** For each ALHEXj (j being 110, 112 or 114), the temperatures that are measured are noted Tₐᵢᵣ₋ₕ₋ⱼ and T_{air-c-j}, h meaning hot and c meaning cold.

The arrangement **100** also preferably comprises at least one (three on figure 3) air temperature sensor ATS for measuring the air temperature on each rack, T_{air-R-i-110}, T_{air-R-i-112}, T_{air-R-i-114}, written more generally T_{air-R-i}.

As shown on FIG. 3, each of the rack-mounted server clusters **130-15L** is fluidly-coupled to a "smart" valve SV that dynamically controls the liquid flow rate of the corresponding processing assembly **130-15L** based on detected liquid temperatures. For purposes of the instant disclosure, the term "smart" valve refers to a valve that is pressure-independent, temperature-responsive, and incorporates a differential pressure regulator to automatically adjust to system pressure changes. Such smart valves may comprise PICVs ("Pressure Independent Control Valves"), like valves of the registered trademark AB-QM, combined with actuators, or other functionally similar valves or combinations of valves, such as a solenoid valve combined with a control valve. On figure 3, the smart valve is referenced to as **160.** The arrangement **100** preferably comprises a rack flow meter sensor FS for measuring the liquid flow rate, noted V of the smart valve. The flow rate varies from a minimal flow rate (preferably null) in a closed state of the smart valve and a maximal flow rate in a fully open state of the smart valve.

The valve **160** could be of any appropriate type of motorized valve.

The arrangement **100** comprises at least one fan. On FIG. 3, the arrangement 100 comprises a respective at least one fan (preferably a plurality of compact fans) dedicated to each heat exchanger **110, 112, 114.** The fans speed is expressed in RPM, for rotation per minute, and a percentage %RPM means a percentage of the maximal RPM for the considered fan model.

Based on the measured T_{R-i} and T_{R-o} of each of the server clusters **130-15L,** the corresponding smart valve can dynamically control the individual liquid flow rate of each of the rack-mounted data processing assemblies to balance and maintain an optimal targeted differential temperature ΔT between the returned heated liquid and the supplied cooling/re-cooled liquid of system **100.** Maintaining this optimal differential temperature ΔT results in improved global cooling system efficiency. In practice, the differential temperature ΔT is positive.

The temperatures of the heat-generating electronic processing elements that are cooled by the liquid cooling blocks arranged to be in respective thermal contact with the electronic processing elements are called processing component temperatures, T_{chips}.

The temperatures of the air cooled elements are noted T_{air cooled IT}.

As can be seen from FIG. 3, the arrangement **100** comprises a leakage device **161** comprising at least one leakage sensor **162** for detecting leaking of the fluid in the circuit **105.**

The sensor can be of any appropriate type. For instance, sensor **162** uses two wires: a wire connected to the ground and another wire connected to a positive voltage source (+) which are generally placed near the floor or any area where a leak is likely to occur. The positive voltage is typically of 3.3V, 5V or 12V. When water comes into contact with both wires, it allows an electric current to flow such that a liquid leak is detected. The sensor generates a signal which can be used to trigger an alarm, or send a notification to a controller **600.**

Additionally or alternatively, the arrangement **100** comprises a water level sensor or any other sensor detecting the presence of water can be used.

As can be seen from FIG. 3, the arrangement **100** comprises a check valve **164.** The check valve **164** can be of any suitable type.

In normal use conditions, i.e., when the arrangement 100 provides liquid to the servers, the smart valve **160** is open and the check valve **164** is open.

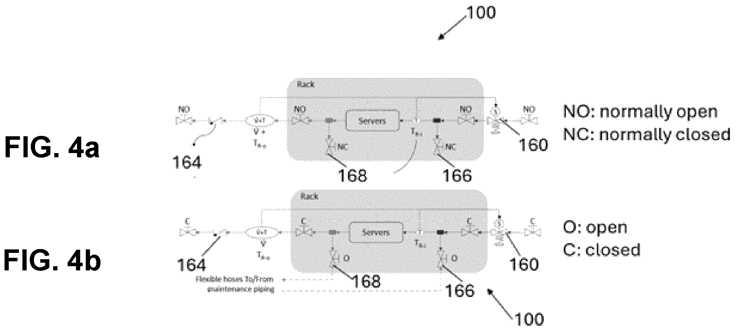

As can be seen from FIG. 3, FIG. 4a and FIG. 4b, the arrangement **100** also comprises another valve **166,** called inlet bypass valve, fluidically disposed downstream the smart valve **160** and upstream an inlet **I** of the water blocks WB of the servers. The inlet bypass valve **166** is configured to be closed in normal use conditions, and open during open conditions, as will be detailed later.

As can be seen from FIG. 4a and 4b, the arrangement **100** also comprises another valve **168,** called outlet bypass valve, fluidically disposed downstream an outlet **O** of the water blocks WB of the servers. The outlet bypass valve **168** is configured to be closed in normal use conditions, and open during maintenance.

The following description now focuses on an operational method **190** of the system **100,** i.e., in the normal-use conditions of the system **100,** for detecting liquid leakage in the arrangement **100.**

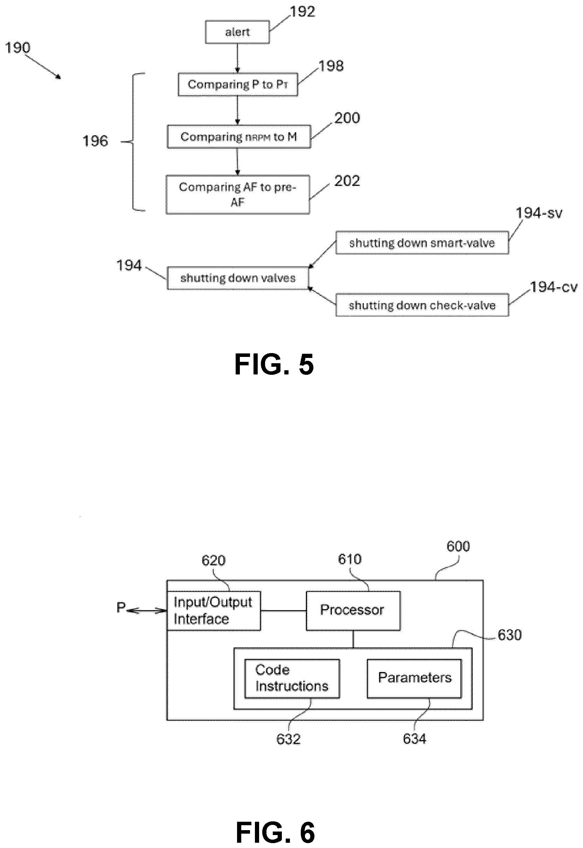

As shown in FIG. 5, method 190 comprises a step **192** of alerting the controller **600** that the leakage sensor **162** has detected a liquid leakage, and a step **194-sv** of shutting off the smart valve **160** and a step **194-cv** for shutting off the check valve **164.**

More precisely, as already explained, leak sensor **162** works by detecting humidity or electrical conductivity of water. When a leak occurs, water comes into contact with the sensor probes, closes an electrical circuit, or changes a measurable property, triggering an alert at step **192** to report the leak. Then, at step **194-sv** the smart valve **160** is shut off. The smart valve **160** being closed, there is less water in the circuit, which implies a pressure drop in the rack. Once this internal liquid pressure becomes lower than a downstream liquid pressure, check valve **164** automatically closes, which isolates the rack from the rest of the system.

Alternatively or additionally, method **190** comprises a step **196** of comparing at least a given parameter to a predetermined value. Said parameter can be a liquid pressure in hose of the liquid cooling arrangement **100** and/or the speed of the pump **172** and/or flow rates of the liquid in the liquid cooling arrangement **100.**

As seen in FIG. 5, at step **198,** method **190** compares the liquid pressure to a threshold pressure PT. And, at step **200,** method **190** compares the speed of the pump **172** to a maximal value M.

According to an embodiment, shutting off the smart valve **160** and the check valve **164** at step **194** occurs not only if step **192** has occurred but also if at step **198** the measured liquid pressure **P** is lower than the threshold pressure PT and/or if a step **200,** the speed nRPM of the pump **172** is higher than the maximum value M.

A decrease in the facility circuit pressure (P<PT) can be a sign of a liquid leakage. Similarly, an increase in the speed of the pump **172** (nRPM>M) can be a sign of liquid leakage.

This embodiment ensures that, rather than relying solely on the leakage sensor alert, step **198** and/ or step **200** perform an extra verification before initiating a shutdown for the rack due to a potential leak.

Preferably, method **190** also comprises a step **202** of comparing the measured flow rate FR to a predetermined value, pre-FR. Then, shutting off the smart valve **160** and the check valve **164** at step **194** occurs not only if step **192** has occurred but also if, at step **198,** the measured liquid pressure P is lower than the threshold pressure PT and/or if a step **200,** the speed nRPM of the pump **172** is higher than the maximum value, and if the measured flow rate FR is of the same order that the predetermined value, for instance FR=pre-FR±20%, for instance FR=pre-FR±10%, for instance FR=pre-FR±5%.

The predetermined value can change over time. For instance, the measured value at a given time is to be compared to the measured value at a previous time, said previous measure being the predetermined value.

This embodiment ensures that the decrease in the liquid pressure and/or speed of the pump is not linked to a change in the liquid flow rate caused by cooling needs.

Method **190** advantageously comprises a step **204** for recording alerts emitted at step **194** to help in post-analysis and troubleshooting.

Following the step **192** of alerting that a potential leak has been detected and the step **194** of shutting down valves **160** and **164,** a maintenance process **206** can be executed.

Maintenance process **206** comprises a step **208** of opening the inlet bypass valve and the outlet bypass valve to provide the servers with cooling liquid, even during maintenance. The inlet bypass valve and the outlet bypass valve are either always connected to a bypass hoses or connected to hoses that are installed only during maintenance operation.

Thanks to method **190,** there is provided a reliable method for detecting and repairing liquid leakages, the method being cost effective, requires less maintenance and requires less valves and fittings for the maintenance bypass.

As indicated above, maintaining optimal differential temperature ΔT results in improved global cooling system efficiency. The method 250 according to the present disclosure aims at maintaining ΔT at a given value, taking into account the flow rate of the cooling liquid, the cold and hot air temperatures, the cold and hot liquid temperatures, the speed of the fans. In another words, the parameters of the method 250 are ΔT, V, T_{R-i}, T_{R-o}, T_{air-c}, Tₐᵢᵣ₋ₕ, Pin_{c}, T_{chips}, T_{air cooled IT}.

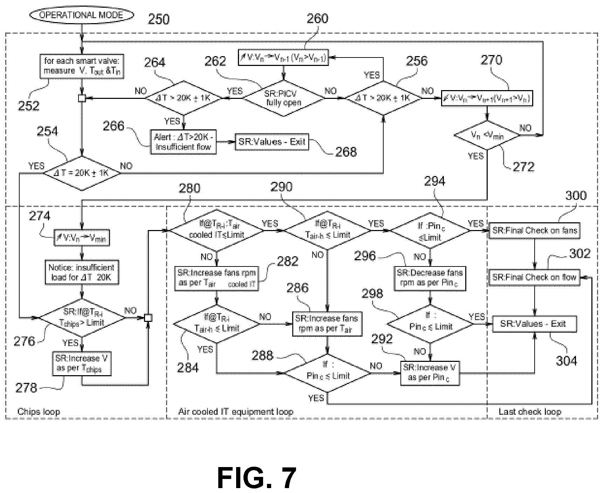

FIG. 7 illustrates a flow diagram of operational process **250** for controlling and balancing the liquid cooling arrangement **100** for rack-mounted data processing assemblies, in accordance with the nonlimiting embodiments of the present technology. In some embodiments, operational process **250** or portions thereof are to be executed by the individual rack-mounted data processing assemblies that are respectively and directly connected to the smart valves. In other embodiments, operational process **250** or portions thereof may be executed by a master control unit that is communicatively coupled to each of the individual rack-mounted data processing assemblies. For purposes of the instant disclosure, the exact entity or entities executing initialization process is not limiting with regard to the concepts provided by the instant disclosure.

Operational process **250** commences at task block **252,** in which for each individual rack-mounted server clusters **130-15L,** the liquid flow rate V of the rack-mounted assembly, the temperature of the heated liquid egressing out of the rack-mounted assembly Tₒᵤₜ, and the temperature of the cooling liquid ingressing into the rack-mounted server clusters **130-15L** Tᵢₙ are measured.

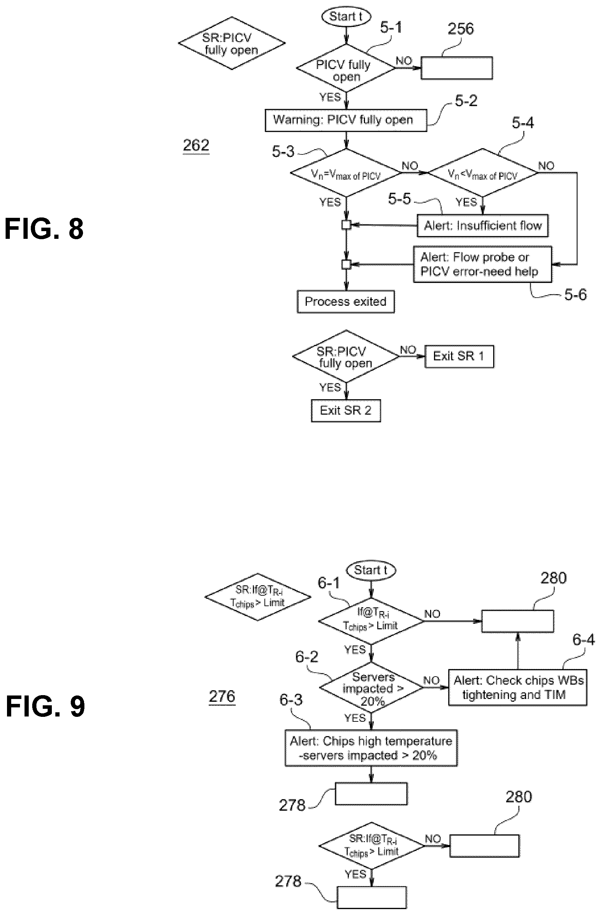

Process **250** then moves to decision block **254,** where it is determined whether the differential temperature ΔT between the egressing heated liquid and the ingressing cooling liquid is negative to a target differential temperature *X* K within a tolerance value ± Z K (FIG. 7 and following show example with X=20 and Z=1). If not, decision block **256** determines whether the differential temperature ΔT is greater than the tolerated target differential temperature *X* K ± Z K and if it is, the liquid flow rate V is incremented by a predetermined value at task block **260.** The process **250** then enters the subroutine 262 of FIG. 8 to determine whether the smart valve (referred to as PICV on the figures) is fully open and, if so, if the incremented liquid flow rate Vₙ is the same as a predetermined maximum flow rate Vₘₐₓ.

As can be seen from this figure, if the smart valve is not fully open (block **5-1),** process **250** returns back to decision block **256.**

If the smart valve is fully open (the fully open state of the smart valve is detected by a position sensor), a warning is issued **(5-2),** then the liquid flow rate is compared to the maximal flow rate (V_{max of PICV}) at step **5-3**. If Vₙ is less than the maximal flow rate **(5-4),** then an alert is issued that the liquid flow rate is insufficient and process **250** issues an alert message **(5-5)** and exits the process (as seen from steps **264-266-268** on Fig. 7). If Vₙ is greater than the maximal liquid flow rate Vₘₐₓ, then an alert **(5-6)** is issued that there might be an error in the functioning of the sensors or the smart valve, that help is needed and process **250** exits the process (as seen from steps **264-266-268** on FIG. 7).

In other words, when the smart valve is in the fully open state, if the flow rate that is measured corresponds to the maximal flow rate, then it is just a warning that is issued whereas if the measured flow rate is not what it is supposed to be, then it is an alert that is issued.

Returning back to decision block **256,** if it is determined that the differential temperature ΔT is not greater than the tolerated target differential temperature *X* K ± Z K, process **250** decrements the liquid flow rate by a predetermined value at task block **270** and then, at decision block **272,** determines whether the decremented liquid flow rate Vₙ₊₁ is less than a predetermined minimum liquid flow rate Vₘᵢₙ. The predetermined minimum liquid flow rate Vₘᵢₙ is configured to prevent laminar flows within the liquid circuit 105.

If decision block **272** determines that Vₙ₊₁ is not less than Vₘᵢₙ, process **250** returns back to task block **252** for the remeasuring of V, Tᵢₙ, and Tₒᵤₜ of the rack-mounted assembly. If decision block 272 determines that Vₙ₊₁ is less than Vₘᵢₙ, process **250** advances to task block **274** to increment the liquid flow rate V by the predetermined value; a notice is issued that there is an insufficient load for the targeted differential temperature ΔT or that there might be an error in the functioning of the sensors or the smart valve.

Returning back to decision block **254,** if it is determined that the differential temperature ΔT is equal to a target differential temperature *X* K within a tolerance value ± Z K, process **250** advances to task block **276** to determine whether, for the temperature of the cooling liquid T_{R-i} (Tᵢₙ), certain internal temperature metrics of the rack-mounted data processing assemblies of server clusters **130-15L**, i.e., processing component temperatures T_{chips}, are less than a predetermined higher temperature limit, as detailed on FIG. 9. Each chip can have a proper limit, or some or all of them can have a same limit.

As can be seen from this figure, at step **6-1,** the T_{chips} temperatures are compared to the limit at T_{R-i}. If decision block **6-1** determines that the processing component temperatures T_{chips} are higher than the limit, process **250** advances to decision block **6-2** to analyze if the quantity of servers that are impacted is greater than a predetermined value (20%, for instance). If the quantity is greater, then process **250** issues an alert **6-3** on the chips temperatures T_{chips} and warns that more than the predetermined value of servers are impacted. The subroutine then exits to task block **278.** If the quantity is smaller than the predetermined value, then process issues an alert to check chips water-blocks tightening and TIM (for "Thermal Interface Material" which is located between the processor and the water block) application on the impacted servers at step **6-4**. Process **250** then exits the subroutine to decision block **280**. If T_{chips} temperatures are not greater than the limit, at decision block **6-1,** process **250** exits the subroutine to decision block **280.**

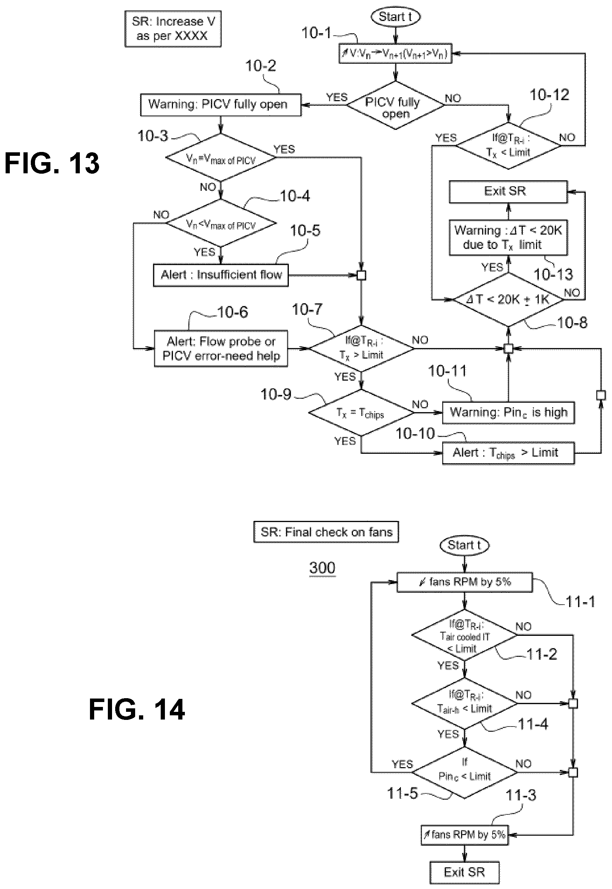

Subroutine **278** will be detailed later, in reference to subroutine **292**, and is illustrated on FIG. 13.

Moving to decision block **280,** process **250** determines whether, for temperature of the cooling liquid T_{R-i}, other internal temperature metrics of the rack-mounted data processing assemblies of server clusters **130-15L,** i.e., air-cooled component temperatures T_{air cooled IT}, are less than or equal to a predetermined higher temperature limit at T_{R-i}.

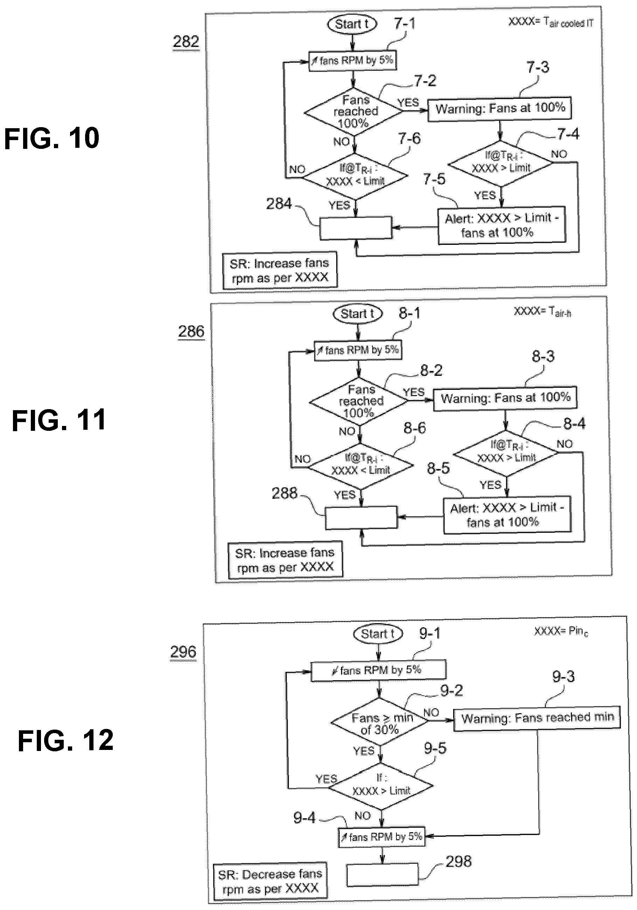

If not, process **250** launches subroutine **282,** as illustrated on FIG. 10. At task block **7-1,** the fans speed is incremented by a predetermined value (5% for instance). Then, it is checked at step **7-2** if the fans speed reaches the maximal speed (100%). If so, a warning is issued that fans are at their maximal speed at step **7-3.** Then, at step **7-4,** the air-cooled component temperatures T_{air cooled IT} are compared again to the limit. If the limit is not reached, then process **250** exits the subroutine to decision block **284.** If the limit is reached, then process **250** issues an alert that the T_{air cooled IT} are greater than the limit and fans are at their maximal speed at step **7-5** and exits the subroutine.

Back to step **7-2,** if the fans speed remains less than the maximal speed, the air-cooled component temperatures T_{air cooled IT} are compared again to the limit at step **7-6.** If the limit is not reached, then process **250** exits the subroutine to decision block **284** whereas if the limit is reached, then process moves back to step **7-1.**

Moving to decision block **284**, process **250** determines whether, for the temperature of the cooling liquid T_{R-i}, hot air flow temperatures Tₐᵢᵣ₋ₕ entering in the ALHEX, are less than or equal to a predetermined higher temperature limit.

If not, process **250** launches subroutine **286,** as illustrated on FIG. 11. At task block **8-1,** the fans speed is incremented by a predetermined value (5% for instance). Then, it is checked at step **8-2** if the fans speed reaches the maximal speed (100%). If so, a warning is issued that fans are at their maximal speed at step **8-3.** Then, at step **8-4,** the hot air flow temperatures Tₐᵢᵣ₋ₕ are compared again to the limit. If the limit is not reached, then process **250** exits the subroutine to decision block **288.** If the limit is reached, then process **250** issues an alert that the Tₐᵢᵣ₋ₕ are greater than the limit and fans are at their maximal speed at step **8-5** and exits the subroutine to decision block **288.**

Back to step **8-2,** if the fans speed remains less than the maximal speed, the air flow temperatures Tₐᵢᵣ₋ₕ are compared again to the limit at step **8-6.** If the limit is not reached, then process **250** exits the subroutine to decision block **288** whereas if the limit is reached, then process **250** returns to step **8-1.**

Back to decision block **284,** if the hot air flow temperatures is less than the limit, then process **250** gets to decision block **288.**

Moving back to decision block **280,** if the air-cooled components temperatures T_{air cooled IT} are less than the higher limit, then hot air flow temperatures Tₐᵢᵣ₋ₕ are compared to the limit (at T_{R-i}) at decision block **290.** If the limit is reached, then process **250** launches already explained subroutine **286.**

Moving to decision block **288,** process **250** determines whether, for the temperature of the cooling liquid Tᵢₙ, cold differences Pin_{c}, are less than or equal to a predetermined higher cold differences limit. If not, then process **250** launches subroutine **292,** as illustrated on FIG. 13.

Back to decision block **290,** if the limit is not reached, then cold differences Pin_{c} are compared to a predetermined limit at decision block **294.** If the limit is reached, then process **250** launches subroutine **296,** as illustrated on FIG. 12.

As can be seen on FIG. 12, at step **9-1,** the fans speed is decremented by a predetermined value (5% for instance). Then, it is checked at step **9-2** if the fans speed reaches a minimal speed (30%, for instance). If so, a warning is issued that fans are at their minimal speed at step **9-3** and the fans speed is incremented by a predefined value (5% for instance) at step **9-4** for security measure, then process **250** exits the subroutine to decision block **298.** Back to step **9-2,** if the fans speed is greater than the minimal speed, then the cold differences Pin_{c} are compared to the limit (and T_{R-i}) at step **9-5.** If the limit is not reached, then process **250** returns to step **9-1.** If the limit is reached, then process **250** executes step **9-4** and exits to decision block **298.**

At decision block **298,** cold differences Pin_{c} are compared again to the limit. If the limit is reached, then process **250** launches subroutine **292,** as illustrated on FIG. 13, which is now described.

On FIG. 13, the subroutine applies either to the processing component temperatures T_{chips} **(278)** or for the Pin_{c} cold temperatures differences **(292).**

As can be seen from this figure, at step **10-1,** the liquid flow rate is incremented by a predetermined value. If the smart valve is fully open, a warning is issued **(10-2).**

The liquid flow rate is compared to the maximal flow rate (V_{max of PICV}) at step **10-3.** If Vₙ is less than the maximal flow rate **(10-4),** then an alert is issued that the liquid flow rate is insufficient and issues an alert message **(10-5).** If Vₙ is greater than the maximal flow rate, then an alert **(10-6)** is issued that there might be an error in the functioning of the sensors or the smart valve, that help is needed and exits the process.

After steps **10-3, 10-5** and **10-6,** the temperature Tₓ (T_{chips} for subroutine **278,** Pin_{c} for subroutine **292)** is compared to a limit (at T_{R-i}) at step **10-7**. If the limit is not reached, the differential temperature ΔT is checked at step **10-8.** If the limit is reached, Tₓ is compared to T_{chips} at step **10-9.** If Tₓ =T_{chips} (i.e., subroutine being executed is **278),** then an alert **(10-10)** is issued that the temperature T_{chips} is greater than its limit and the differential temperature ΔT is checked at step **10-8.** Back to step **10-9,** if Tₓ differs from T_{chips} (i.e., subroutine being executed is **292),** then a warning is issued **(10-11)** that P_{inc} is high and process **250** goes on to step **10-8.**

Back to step **10-1,** if the smart valve is not fully open, Tₓ is compared to its limit **(10-12)** at T_{R-i}. If the limit is reached, then process **250** gets back to step **10-1.** If the limit is not reached, then the differential temperature ΔT is checked at step **10-8.**

At step **10-8,** if the differential temperature ΔT is less than the tolerated target differential temperature *X* K ± Z K, a warning is issued **(10-13)** that the differential temperature ΔT is smaller than the target and process **250** exits subroutine **292/278.** At step **10-8,** if the differential temperature ΔT is not smaller than the tolerated target differential temperature *X* K ± Z K, process **250** exits subroutine **292/278.**

When subroutine **292** is exited, process **250** launches subroutine **304.**

Back to decision block **294,** if cold differences Pin_{c} are less than the predetermined limit, then process **250** launches subroutine **300** of a final check of the fans, as illustrated on FIG. 14.

As can be seen from FIG. 14, the fans speed is decremented by a predetermined value (5% for instance), without going under a predetermined value (30% for instance) at task block **11-1.**

Then, at step **11-2,** the temperatures T_{air cooled IT} are compared to the limit at T_{R-i}. If the limit is reached, the fans speed is incremented by a predetermined value (5% for instance) at step **11-3** and process **250** exits subroutine **300.** Back to step **11-2,** if the limit is not reached, then, at step **11-4,** the temperatures Tₐᵢᵣ₋ₕ are compared to the limit at T_{R-i}. If the limit is reached, the fans speed is incremented by a predetermined value (5% for instance) at step **11-3** and process **250** exits subroutine **300.** Back to step **11-4,** if the limit is not reached, then, at step **11-5,** then cold differences Pin_{c} are compared to the limit at T_{R-i}. If the limit is reached, the fans speed is incremented by a predetermined value (5% for instance) at step **11-3** and process **250** exits subroutine **300.** At step **11-5,** if the limit is not reached, then subroutine **300** returns back to step **11-1.**

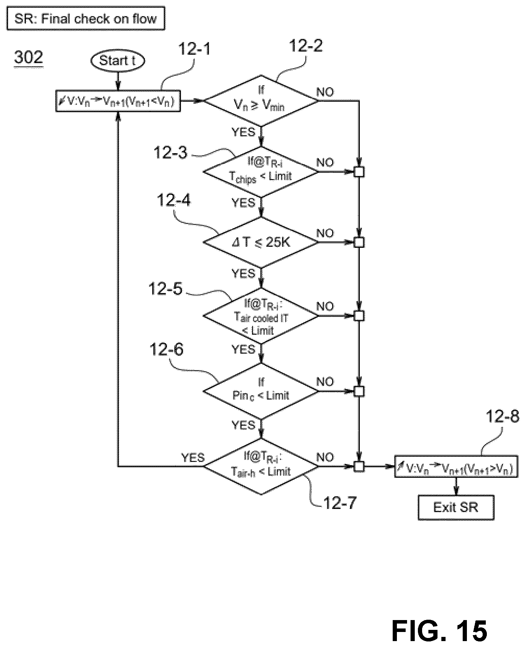

When subroutine **300** is finished, process **250** launches subroutine **302** of a final check of the liquid flow rate, as illustrated on FIG. 15.

As can be seen from this figure, process **250** decrements the liquid flow rate by a predetermined value at task block **12-1** and then, at step **12-2,** determines whether the decremented liquid flow rate is less than or equals the predetermined minimum liquid flow rate Vₘᵢₙ. If Vₙ is greater than the minimum, then, the temperatures T_{chips} are compared to their limits (at T_{R-i}) at step **12-3.** If the limit is not reached then, at step **12-4,** the differential temperature ΔT is compared to a target higher than the previous *X* target (FIG. 15 shows an example with 25 K as a target while considering X equals 20). If the limit is not reached, then, at step **12-5,** the temperatures T_{air cooled IT} are compared to their limits at T_{R-i}. If the limit is not reached, then, at step **12-6,** the cold differences Pin_{c} are compared to their limit (the same limit applies to each Pin_{c}). If the limit is not reached, then, at step **12-7,** Tₐᵢᵣ₋ₕ is compared to its limit at T_{R-i}. If the limit is not reached, then process **250** returns back to step **12-1.**

At each of step **12-2, 12-3, 12-4, 12-5, 12-6** and **12-7,** if the limit is reached then the liquid flow rate is incremented to by a predetermined value at task block **12-8** and process **250** exits subroutine **302.**

When subroutine **302** is finished, process **250** launches subroutine **304** of a final review of the values. During subroutine **304,** the values to be published are recorded, i.e., the liquid flow rate (m³/h), the differential temperature (K), the temperatures being parameters of process 250 (K), the opening of the smart valve (%), the fans speed (%), the Pin_{c} (K), ...

Process **250** can be launched at a given frequency, for instance each 20 min, for instance each 10 min, for instance 5 min, for instance 1 min, or the frequency can be correlated to a change of the rack electrical power, or on IT demand.

The method of the present disclosure first imposes the differential temperature ΔT to a predetermined target, then the internal temperatures T_{chips} of the rack-mounted processing assembly are controlled to remain smaller than the predetermined limit (by increasing the liquid flow rate when needed), then the air-cooled electronic processing elements T_{air cooled IT} temperatures are controlled to remain smaller than the predetermined limit (by increasing the fans speed when needed), then hot air flow temperatures Tₐᵢᵣ₋ₕ are controlled to remain smaller than the predetermined limit (by increasing the fans speed when needed), and finally the cold differences Pin_{c} are also controlled to remain smaller than the predetermined limit (by increasing the liquid flow rate when needed, and by decreasing the fans speed when needed).

Thanks to the present invention, the differential temperature (ΔT) is optimized and maintained, which ensures a better efficiency of the dry cooler unit (e.g. by allowing a reduction of its fan speed rotation), and the temperatures of the datacenter ambience and the components are both guaranteed to be acceptable. Accordingly, as the energy efficiency is increased, the Operating Expense is reduced.

The method **250** can be executed using a controller **600** depicted by the high-level functional block diagram of FIG. 6. As shown, the controller **600** comprises a processor or a plurality of cooperating processors (represented as a processor **610** for simplicity), a memory device or a plurality of memory devices (represented as a memory device **630** for simplicity), and an input/output interface **620** (or separate input and output interfaces) allowing the controller **600** to communicate with certain components of the liquid cooling arrangement **100.** The processor **610** is operatively connected to the memory device **630** and to the input/output interface **620.** The memory device **630** includes a storage for storing parameters **634,** including for example and without limitation the above-mentioned pre-determined conductivity thresholds. The memory device **630** may comprise a non-transitory computer-readable medium for storing code instructions **632** that are executable by the processor **610** to allow the controller 600 to perform the various tasks allocated to the controller **600.**

The controller **600** is operatively connected, via the input/output interface **620,** to the components of liquid cooling arrangement **100,** such as, the temperature sensors that measures the P parameters. The controller **600** executes the code instructions **632** stored in the memory device **630** to implement the various above-described steps of the method **250.**

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

Advantageously, there is one Pin_{c} by ALHEX, and there can also be one fan speed by ALHEX. In this case, the subroutines of Pin_{c} and fan speed should preferably be executed in parallel, for each ALHEX (on the contrary, there is preferably one flow rack by rack, implying that the Pin_{c} used to check if the flow rate should be increased can be the maximal Pin_{c}).

Modifications and improvements to the above-described implementations of the present technology may become apparent to those skilled in the art. The foregoing description is intended to be exemplary rather than limiting. The scope of the present technology is therefore intended to be limited solely by the scope of the appended claims.

## Claims

1. A fluid cooling system for rack-mounted data processing assemblies of a datacenter, comprising:
a cooling facility (170) to supply a cooling liquid to the rack-mounted data processing assemblies and receive a heated liquid from the rack-mounted data processing assemblies;
a liquid distribution circuit (105) to convey a cooling liquid from the cooling facility to the rack-mounted data processing assemblies, the liquid distribution circuit (105) comprising at least one heat exchanger (ALHEX) configured to cool an air flow of the rack with the cooling liquid;
wherein, each of the rack-mounted data processing assemblies comprises:
at least one heat-generating electronic processing element and at least one liquid cooling block arranged to be in respective thermal contact with the at least one heat-generating electronic processing element, the at least one liquid cooling block being fluidly-coupled to the liquid distribution circuit to receive the cooling liquid and circulate therethrough, and
a control valve (160) respectively arranged to be fluidly-coupled to the at least one liquid cooling block of the corresponding rack-mounted data processing assembly,
wherein at least one electronic processing element is being air-cooled,
wherein the fluid cooling system comprises a leakage detection device to detect leakage of liquid,
the leakage detection device comprising said control valve as an inlet shut off actuator when a liquid leakage is detected, and a check valve to act as the outlet shut off actuator when a liquid leakage is detected.

2. The fluid cooling system of the preceding claim, comprising a bypass line connected to a rack inlet and to a rack outlet.

3. The fluid cooling system of the preceding claim, wherein the bypass line comprises a first valve, called bypass inlet valve, fluidically disposed downstream the control valve and upstream the rack mounted assemblies, the bypass inlet valve being configured to be closed in normal use conditions of the fluid cooling system.

4. The fluid cooling system of the preceding claim, wherein the bypass line comprises a second valve, called bypass outlet valve, fluidically disposed downstream the control valve and the rack mounted assemblies and upstream the check valve, the bypass outlet valve being configured to be closed in normal use conditions of the fluid cooling system.

5. The fluid cooling system of any of the preceding claims, wherein the control valve is a smart control valve, configured to be pressure independent and controls the flow rate of the cooling fluid of the corresponding rack-mounted data processing assembly based on detected temperatures and monitored flow rate.

6. The fluid cooling system of any of the preceding claims, wherein the control valve is located in the rack inlet and the check valve is located in the rack outlet.

7. The fluid cooling system of any of the preceding claims, wherein the leakage device comprises a leakage sensor, the leakage sensor comprising an electrical circuit configured to be open in normal use conditions of the fluid cooling system and to be closed in case of liquid leak and/or a pressure sensor.

8. A method for detecting liquid leakage in the fluid cooling system of claims 1-7, comprising:
- alerting a controller that the leakage sensor has detected a liquid leakage, and
- shutting off the control valve and the check valve.

9. The method of the preceding claim, wherein shutting off the control valve is controlled by a control panel of the fluid cooling system.

10. The method of claim 8 or 9, wherein shutting off the check valve is automatically done when a pressure of liquid upstream the check valve is lower than a pressure of liquid downstream the check valve.

11. The method of any claims 8-10, comprising a maintenance step ulterior to the step of shutting off the control valve and the check valve, said step comprising opening the bypass inlet valve and bypass outlet valve.

12. The method of the preceding claim, wherein the method comprising
- comparing liquid pressure in the system to a pressure threshold and/or
- comparing pump speed to a speed threshold,
the shutting off the smart valve and the check valve occurring only if the step of alerting a controller that the leakage sensor has detected a liquid leakage occurs and if
- the liquid pressure is lower than or equal to the pressure threshold, and/or
- the pump speed is higher than or equal to the speed threshold.

13. The method of the preceding claim, further comprising
- comparing the flow rate to a pre-determined value,
the shutting off the smart valve and the check valve occurs only if the step of alerting a controller that the leakage sensor has detected a liquid leakage occurs and if
- the liquid pressure is lower than or equal to the pressure threshold, and/or
- the pump speed is higher than or equal to the speed threshold,
and if
the flow rate is of the same order as or lower than the pre-determined value.

14. A computer program comprising instructions which, when the program is executed by a computer, cause the computer to carry out the steps of the method of any of claims 8 to 13.

15. A computer-readable medium comprising instructions which, when executed by a computer, cause the computer to carry out the steps of the method of any of claims 8 to 13.

## Amended claims

### Amended claims in accordance with Rule 137(2) EPC.

1. A fluid cooling system for rack-mounted data processing assemblies of a datacenter, comprising:
a cooling facility (170) to supply a cooling liquid to the rack-mounted data processing assemblies and receive a heated liquid from the rack-mounted data processing assemblies;
a liquid distribution circuit (105) to convey a cooling liquid from the cooling facility to the rack-mounted data processing assemblies, the liquid distribution circuit (105) comprising at least one heat exchanger (ALHEX) configured to cool an air flow of the rack with the cooling liquid;
wherein, each of the rack-mounted data processing assemblies comprises:
at least one electronic processing element that is being air-cooled,
at least one heat-generating electronic processing element and at least one liquid cooling block arranged to be in respective thermal contact with the at least one heat-generating electronic processing element, the at least one liquid cooling block being fluidly-coupled to the liquid distribution circuit to receive the cooling liquid and circulate therethrough, and
a control valve (160) respectively arranged to be fluidly-coupled to the at least one liquid cooling block of the corresponding rack-mounted data processing assembly,
wherein the fluid cooling system comprises a leakage detection device to detect leakage of liquid,
the leakage detection device comprising said control valve as an inlet shut off actuator when a liquid leakage is detected, and a check valve to act as the outlet shut off actuator when a liquid leakage is detected.

2. The fluid cooling system of the preceding claim, comprising a bypass line connected to a rack inlet and to a rack outlet.

3. The fluid cooling system of the preceding claim, wherein the bypass line comprises a first valve, called bypass inlet valve, fluidically disposed downstream the control valve and upstream the rack mounted assemblies, the bypass inlet valve being configured to be closed in normal use conditions of the fluid cooling system.

4. The fluid cooling system of the preceding claim, wherein the bypass line comprises a second valve, called bypass outlet valve, fluidically disposed downstream the control valve and the rack mounted assemblies and upstream the check valve, the bypass outlet valve being configured to be closed in normal use conditions of the fluid cooling system.

5. The fluid cooling system of any of the preceding claims, wherein the control valve is a smart control valve, configured to be pressure independent and controls the flow rate of the cooling fluid of the corresponding rack-mounted data processing assembly based on detected temperatures and monitored flow rate.

6. The fluid cooling system of any of the preceding claims, wherein the control valve is located in the rack inlet and the check valve is located in the rack outlet.

7. The fluid cooling system of any of the preceding claims, wherein the leakage device comprises a leakage sensor, the leakage sensor comprising an electrical circuit configured to be open in normal use conditions of the fluid cooling system and to be closed in case of liquid leak and/or a pressure sensor.

8. A method for detecting liquid leakage in the fluid cooling system of claims 1-7, comprising:
- alerting a controller that the leakage sensor has detected a liquid leakage, and
- shutting off the control valve and the check valve.

9. The method of the preceding claim, wherein shutting off the control valve is controlled by a control panel of the fluid cooling system.

10. The method of claim 8 or 9, wherein shutting off the check valve is automatically done when a pressure of liquid upstream the check valve is lower than a pressure of liquid downstream the check valve.

11. The method of any claims 8-10, comprising a maintenance step ulterior to the step of shutting off the control valve and the check valve, said step comprising opening the bypass inlet valve and bypass outlet valve.

12. The method of the preceding claim, wherein the method comprising
- comparing liquid pressure in the system to a pressure threshold and/or
- comparing pump speed to a speed threshold,
the shutting off the smart valve and the check valve occurring only if the step of alerting a controller that the leakage sensor has detected a liquid leakage occurs and if
- the liquid pressure is lower than or equal to the pressure threshold, and/or
- the pump speed is higher than or equal to the speed threshold.

13. The method of the preceding claim, further comprising
- comparing the flow rate to a pre-determined value,
the shutting off the smart valve and the check valve occurs only if the step of alerting a controller that the leakage sensor has detected a liquid leakage occurs and if
- the liquid pressure is lower than or equal to the pressure threshold, and/or
- the pump speed is higher than or equal to the speed threshold,
and if
the flow rate is of the same order as or lower than the pre-determined value.

14. A computer program comprising instructions which, when the program is executed by a computer, cause the computer to carry out the steps of the method of any of claims 8 to 13.

15. A computer-readable medium comprising instructions which, when executed by a computer, cause the computer to carry out the steps of the method of any of claims 8 to 13.
